# EUROPEAN PATENT APPLICATION

(11) **EP 4 266 350 A1**
(43) Date of publication of application: **25.10.2023**
(21) Application number: 21906422.7
(22) Date of filing: 06.12.2021
(51) Int. Cl.: H01L 21/20, H01L 29/06, H01L 29/20, H01L 29/47, H01L 29/872, H01L 21/329, H01L 29/861, H01L 29/868

(54) **METHOD FOR MANUFACTURING SEMICONDUCTOR ELEMENT, SEMICONDUCTOR ELEMENT, AND SEMICONDUCTOR DEVICE**

(30) Priority: 17.12.2020 JP 2020209672
(71) Applicant: Kyocera Corporation, Kyoto-shi Kyoto 612-8501 (JP)
(72) Inventor: AZUMA, Katsunori, Kyoto-shi, Kyoto 612-8501 (JP); MASAKI, Katsuaki, Kyoto-shi, Kyoto 612-8501 (JP); FUJITA, Kokichi, Kyoto-shi, Kyoto 612-8501 (JP); HAYASHI, Yuichiro, Kyoto-shi, Kyoto 612-8501 (JP); HIRAYAMA, Tomohisa, Kyoto-shi, Kyoto 612-8501 (JP); SAWADA, Tatsuro, Kyoto-shi, Kyoto 612-8501 (JP); KASAI, Hayao, Kyoto-shi, Kyoto 612-8501 (JP)
(74) Representative: Viering, Jentschura & Partner mbB Patent- und Rechtsanwälte
(86) International application number: PCT/JP2021/044789
(87) International publication number: WO 2022/131059

(57) **Abstract**

A manufacturing method for a semiconductor element includes forming a mask (21) on a front surface (11a) of a substrate (11), the mask having an opening to expose the front surface, growing a GaN layer (32), which is a first semiconductor layer by epitaxially growing a semiconductor along the mask (21), starting from the front surface (11a) exposed through the opening (22), and growing a GaN layer (33), which is a second semiconductor layer. On a surface (33a) located opposite to the substrate 11 in a layering direction and on which a Schottky electrode (41) is provided, a width (w2) from an end portion of the surface (33a) to the Schottky electrode (41) is smaller than a width (w1) of the mask (21).

## Description

### TECHNICAL FIELD

The present disclosure relates to a manufacturing method for a semiconductor element, a semiconductor element, and a semiconductor device.

### BACKGROUND OF INVENTION

A Schottky barrier diode (SBD) made by an epitaxial lateral overgrowth (ELO) method using a free-standing GaN substrate is described in Patent Document 1.

### CITATION LIST

### PATENT LITERATURE

Patent Document 1: JP 6070422 B

### SUMMARY

In one aspect, a method of manufacturing a semiconductor element includes forming a mask on a front surface of a substrate, the mask having an opening to expose the front surface, growing a first semiconductor layer by epitaxially growing a semiconductor along the mask, starting from the front surface exposed through the opening, and growing a second semiconductor layer, and on a surface located opposite to the substrate in a layering direction and providing an electrode located opposite to the surface of the first semiconductor layer in the layering direction, a width from an end portion of the surface to the electrode is smaller than a width of the mask.

In one aspect, a semiconductor element is manufactured by the method of manufacturing a semiconductor element, and the mask is interposed between the substrate and the first semiconductor layer inside the semiconductor element.

In one aspect, a semiconductor device includes a semiconductor element manufactured by the method of manufacturing a semiconductor element.

### BRIEF DESCRIPTION OF THE DRAWINGS

FIG. 1 is a cross-sectional schematic view for describing a semiconductor element according to an embodiment.
FIG. 2 is a cross-sectional schematic view for describing a manufacturing method for the semiconductor element and the semiconductor element according to the embodiment.
FIG. 3 is a plan schematic view for describing the semiconductor element according to the embodiment.
FIG. 4 is a schematic view for describing the semiconductor elements and a semiconductor device according to the embodiment.
FIG. 5 is a flowchart for describing the manufacturing method for the semiconductor element according to the embodiment.
FIG. 6 is a flowchart for describing a manufacturing method for the semiconductor device according to the embodiment.
FIG. 7 is a cross-sectional schematic view for describing an example of a semiconductor element according to a first variation of the embodiment.
FIG. 8 is a flowchart for describing a manufacturing method for a semiconductor device according to the first variation of the embodiment.
FIG. 9 is a cross-sectional schematic view for describing a semiconductor element according to a second variation of the embodiment.
FIG. 10 is a cross-sectional schematic view for describing a semiconductor element according to a third variation of the embodiment.

### DESCRIPTION OF EMBODIMENTS

An SBD manufactured using a free-standing GaN substrate may have crystal defects in various directions in a voltage resistant end portion of a surface on which an anode electrode is provided. When the crystal defects occur on the surface along a direction of an electric field in the voltage resistant end portion, an impurity level that serves as a source of leakage occurs even when the surface is covered with an insulating film. Thus, the crystal defects that occur along the direction of the electric field serve as paths for leakage current. This reduces the voltage resistance of the SBD.

A manufacturing method for a semiconductor element 1, the semiconductor element 1, and a semiconductor device 2, according to the embodiment will be described below. The semiconductor element 1 is a power semiconductor used in switching circuits of power converters such as inverters and converters.

### Embodiment

### Manufacturing Method

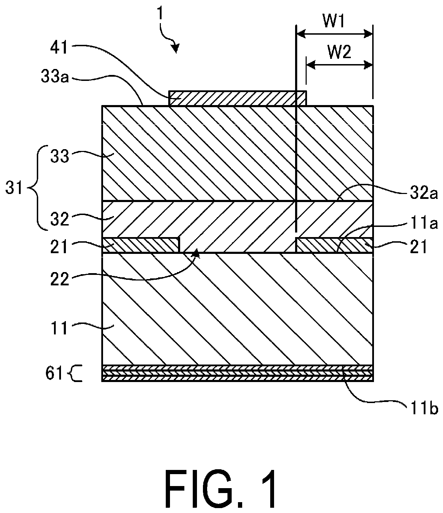

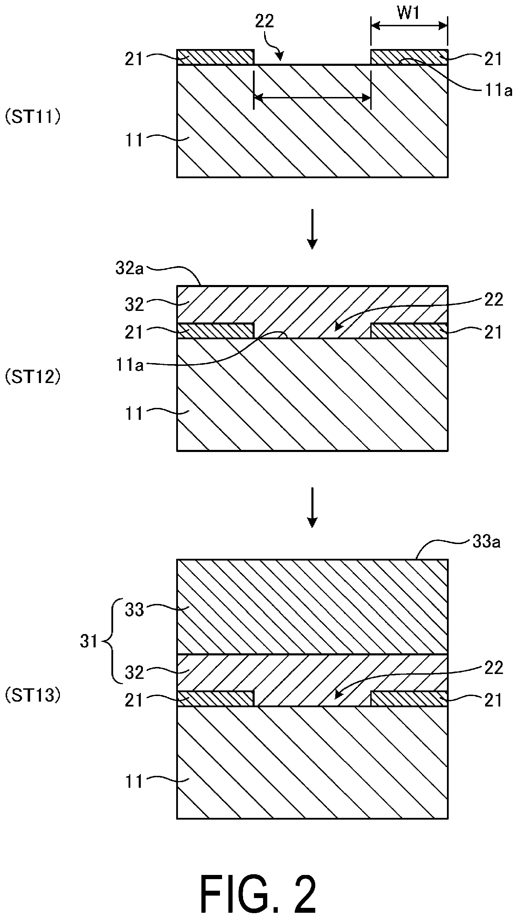

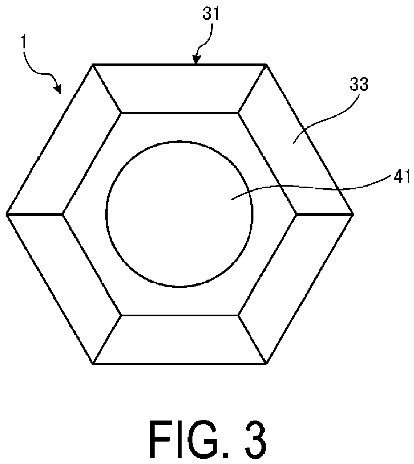

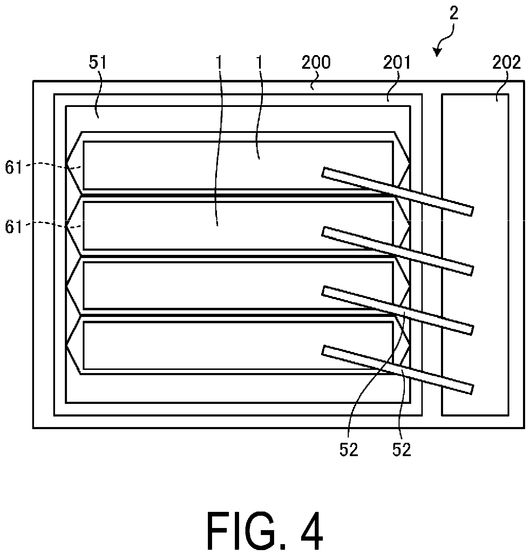

FIG. 1 is a cross-sectional schematic view for describing the semiconductor element according to the embodiment. FIG. 2 is a cross-sectional schematic view for describing the manufacturing method for the semiconductor element and the semiconductor element according to the embodiment. FIG. 3 is a plan schematic view for describing the semiconductor element according to the embodiment. FIG. 4 is a schematic view for describing the semiconductor elements and the semiconductor device according to the embodiment.

As illustrated in FIG. 1 to FIG. 3, in the semiconductor element 1 manufactured by the manufacturing method according to the embodiment, a semiconductor layer 31 is formed on a substrate 11. In the semiconductor layer 31, a GaN layer (first semiconductor layer) 32, which is an n+ type semiconductor layer, and a GaN layer (second semiconductor layer) 33, which is an n- type semiconductor layer, are layered in order from the substrate 11 side. Inside the semiconductor element 1, a mask 21 is interposed between the substrate 11 and the GaN layer 32. As illustrated in FIG. 4, the semiconductor device 2 includes the semiconductor elements 1 manufactured in this manner.

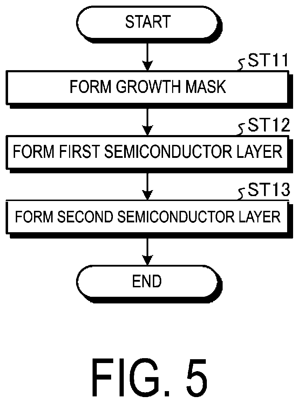

The manufacturing method for the semiconductor element 1 will be described with reference to FIGs. 1, 2, and 5. FIG. 5 is a flowchart for describing the manufacturing method for the semiconductor element according to the embodiment. The manufacturing method for the semiconductor element 1 is performed in accordance with steps illustrated in FIG. 5.

The substrate 11 illustrated in FIGs. 1 and 2 is n+ type free-standing GaN. The doping amount of n-type impurities is controlled so that the substrate 11 has an electron carrier concentration of equal to or higher than 10¹⁸ cm⁻³.

A back surface 11b on the opposite side to a front surface 1 1a of a GaN layer, which is a surface layer of the substrate 11, may be supported by a substrate other than the GaN substrate, such as a silicon substrate (not illustrated). The substrate that supports the back surface 11b of the GaN layer, which is the surface layer of the substrate 11, may be, for example, a sapphire substrate or a silicon carbide (SiC) substrate.

First, the mask 21 made of SiO₂ is formed on the front surface 11a of the GaN layer, which is the surface layer of the substrate 11, illustrated in FIG. 2 (step ST11) (first step). More specifically, the mask 21 having an opening 22 is provided on the front surface 11a of the substrate 11.

The mask 21 may contain an element that serves as a donor in the semiconductor layer 31. Examples of a material of the mask 21 may include metals such as W and Ti, nitrides such as SiN and AIN, and oxides such as Al₂O₃ and Ga₂O₃. The mask 21 may be amorphous. The mask 21 includes the opening 22.

A portion of the front surface 11a of the substrate 11 corresponding to the opening 22 is exposed through the opening 22 of the mask 21. The mask 21 may cover the front surface 1 1a at both ends of the substrate 11. The mask 21 may cover the entire side surface or back surface of the substrate 11. The mask 21 may cover the entirety excluding the opening 22, of the surfaces that may come into contact with a raw material gas used in a vapor growth method, which will be described below.

A width w1 of the mask 21 in a lateral direction orthogonal to a layering direction is, for example, 10 µm or more. The thickness of the mask 21 in the layering direction is, for example, 100 nm.

As illustrated in FIG. 2, the GaN layer is formed as the semiconductor layer 31 from the front surface 1 1a of the substrate 11 exposed through the opening 22 using the ELO technique described above (step ST12) (second step). More specifically, using the ELO technique, an epitaxial apparatus (not illustrated) epitaxially grows GaN along the mask 21 from the front surface 1 1a of the substrate 11 exposed through the opening 22 to epitaxially grow an n+ type GaN layer 32 with a high impurity concentration.

The GaN layer 32 grows, from the front surface 11a exposed through the opening 22, longitudinally above the opening 22 in the layering direction, and laterally outside the opening 22. A surface 32a of the GaN layer 32 becomes substantially flat. The GaN layer 32 is auto-doped with impurities from the constituent material of the mask 21 during crystal growth. When the impurity is silicon (Si), the GaN layer 32 is a highly doped n+ semiconductor layer. The doping amount of n-type impurities is controlled so that the GaN layer 32 has an electron carrier concentration equal to or higher than 10¹⁸ cm⁻³. When the doping amount is insufficient in auto-doping, an impurity (for example, Si) may be doped during epitaxial growth. The thickness of the GaN layer 32 in the layering direction is, for example, 10 µm or more.

In order to obtain a desired impurity concentration profile, the GaN layer 33 with a low impurity concentration is formed so as to cover the GaN layer 32 (step ST13) (third step). More specifically, the n- type GaN layer 33 with a low impurity concentration is formed from the surface 32a of the GaN layer 32.

The GaN layer 33 is grown from the surface 32a of the GaN layer 32 by selecting conditions in which longitudinal growth is dominant over lateral growth. A surface 33a of the GaN layer 33 becomes substantially flat. The surface 33a of the GaN layer 33 is located on the opposite side to the substrate 11 in the layering direction and is a surface on which an upper surface electrode is provided. The GaN layer 33 is an n- semiconductor layer. The doping amount of n-type impurities is controlled so that the GaN layer 33 has an electron carrier concentration lower than 10¹⁷ cm⁻³. During the epitaxial growth, the GaN layer 33 is not in contact with the mask 21 and is covered with the GaN layer 32, so that the auto-doping is reduced. The GaN layer 32 covers a large portion of the mask 21, so that the auto-doping of the GaN layer 33 is also reduced. The thickness of the GaN layers 33 in the layering direction is, for example, 5 µm or more for an element with a breakdown voltage of 600 V.

As described above, as illustrated in FIGs. 1 and 2, a semiconductor is epitaxially grown along the mask 21 from the front surface 11a exposed through the opening 22 to produce the semiconductor element 1 including the semiconductor layer 31. The semiconductor layer 31 is formed on the substrate 11. The GaN layer 32, which is an n+ type semiconductor layer, and the GaN layer 33, which is an n- type semiconductor layer, are epitaxially grown from the front surface of the substrate 11 in the layering direction.

As illustrated in FIG. 3, the semiconductor element 1 has a hexagonal shape when viewed from above in the layering direction. This is because the growth direction of the crystal in epitaxial growth is determined. In the semiconductor layer 31 of the semiconductor element 1, crystals grow longitudinally above the opening 22 in the layering direction, and laterally on the outside of the opening 22. As a result, the crystal defects on the surface 33a of the GaN layer 33 of the semiconductor element 1 extend longitudinally in the center portion, and extend laterally on the outside of the center portion.

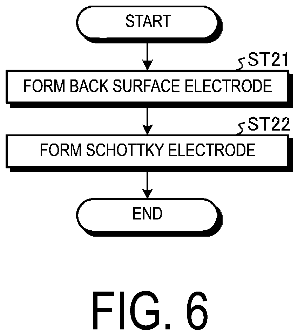

A manufacturing method for the semiconductor device 2 including the semiconductor element 1 will be described with reference to FIG. 1 and FIG. 6. FIG. 6 is a flowchart for describing a manufacturing method for the semiconductor device according to the embodiment. The manufacturing method for the semiconductor device 2 is performed in accordance with steps illustrated in FIG. 6 after the semiconductor element 1 is manufactured in accordance with steps illustrated in FIG. 5. Step ST21 to step ST22 are performed after performing step ST11 to step ST13.

Back surface electrodes 61 are formed on the back surface 11b of the substrate 11 on the opposite side to the semiconductor layer 31 (step ST21). More specifically, the back surface electrodes 61 are formed on the back surface 11b of the substrate 11 by, for example, sputtering.

The back surface electrodes 61 are obtained by, for example, performing Ti/Ni/Au plating on an Al layer. Note that the back surface electrodes 61 may be formed after a Schottky electrode 41, which will be described below, is formed. In the manufacturing method including a step of increasing a temperature, for example, by performing step ST21 last, the influence on the back surface electrodes 61 can be avoided.

The Schottky electrode 41, which is a metal layer (barrier metal), is formed on the surface 33a of the GaN layer 33 of the semiconductor layer 31 (step ST22). Thus, a Schottky junction is provided between the GaN layer 33 and the Schottky electrode 41.

The Schottky metal film 41 is made of, for example, Ni, Al, or Pd. The Schottky metal film 41 is located on the opposite side to the substrate 11 in the layering direction. The Schottky metal film 41 is provided in the center portion of the surface 33a of the GaN layer 33. A width w2 from an end portion of the surface 33a of the GaN layer 33 to the Schottky metal film 41 (width of the voltage resistant end portion) is smaller than the width w1 of the mask 21. On the surface 33a of the GaN layer 33, an area from the end portion of the surface 33a to the Schottky metal film 41 is referred to as a voltage resistant end portion.

In the above-described manner, the semiconductor element 1 is manufactured. The manufactured semiconductor element 1 can be used as, for example, an SBD having a Schottky junction. Inside the manufactured semiconductor element 1, the mask 21 is interposed between the substrate 11 and the GaN layer 32.

The manufacturing processes described above may be performed concurrently so as to simultaneously manufacture a plurality of semiconductor elements 1. In this case, the mask 21 is formed with a plurality of openings 22 in a striped pattern. By making one semiconductor element 1 correspond to one opening 22, the plurality of semiconductor elements 1 can be simultaneously made.

When the mask has a striped pattern, each crystal has a hexagonal shape with two long sides, and a cross-sectional view of the crystals with the two long sides is as illustrated in FIG. 4.

The semiconductor elements 1 manufactured simultaneously may be separated into individual pieces and used in the semiconductor devices 2, respectively. When the capacity needs to be increased, for example, while the substrate 11 and the back surface electrodes 61 are shared by the plurality of semiconductor elements 1, the plurality of semiconductor elements 1 may be mounted for use in the semiconductor device 2, as illustrated in FIG. 4. Specifically, as illustrated in FIG. 4, the back surface electrodes 61 that are shared are each die-bonded to a corresponding one of the electrode pads 201 on a mounting substrate 200, and individual upper surface electrode metal films (not illustrated) are connected to another electrode pad 202 by bonding wires 52. By mounting the mounting substrate 200 in this manner, a plurality of diodes can be connected in parallel to increase the capacity and be used. At this time, the plurality of semiconductor elements 1 are manufactured so as to be aligned and disposed in a certain direction. In the layering direction view, the semiconductor elements 1 each have a shape elongated in a substantially orthogonal direction with respect to a direction in which the semiconductor elements 1 are aligned. Aligning the semiconductor elements 1 having such a shape in this manner can increase a junction area of the diode. The semiconductor elements 1 manufactured in this manner are available for a variety of semiconductor devices 2 according to applications.

As described above, in the present embodiment, the mask 21 is interposed between the substrate 11 and the GaN layer 32 inside the semiconductor element 1. In the present embodiment, the width w2 from the end portion of the surface 33a of the GaN layer 33 to the Schottky metal film 41 is smaller than the width w1 of the mask 21. In the present embodiment, crystals grow longitudinally above the opening 22 in the layering direction, and laterally on the outside of the opening 22. In the present embodiment, the direction of crystal defects in the voltage resistant end portion is the lateral direction. As a result, according to the present embodiment, the occurrence of crystal defects along the direction of the electric field, which may serve as paths for leakage current of the semiconductor element 1, can be reduced in the voltage resistant end portion. In the present embodiment, the voltage resistance of the SBD can be improved.

In the present embodiment, the width w1 of the mask 21 is, for example, 10 µm or more. In this variation, the width w2 (< w1) of the voltage resistant end portion can be narrowed. According to this variation, the ratio of the conductive area of the semiconductor element 1 can be increased. In the present embodiment, the semiconductor element 1 can be reduced in size, thereby reducing costs.

### First Variation

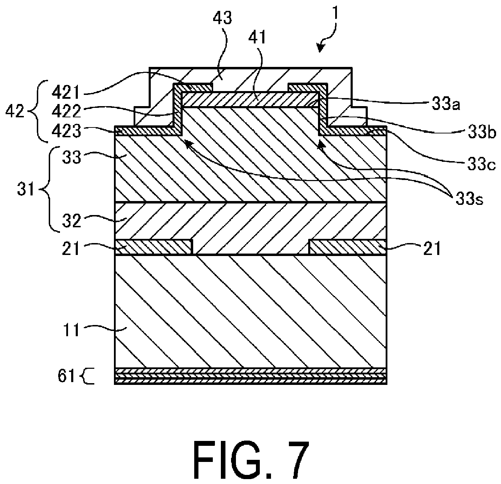

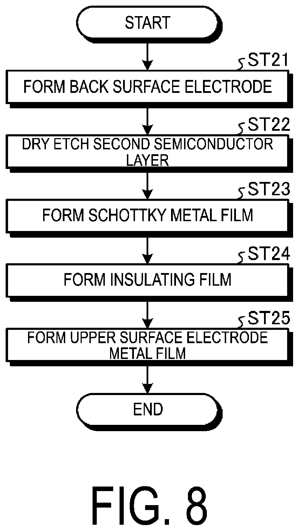

A description is given of a first variation of the embodiment using FIGs. 7 and 8. FIG. 7 is a cross-sectional schematic view for describing an example of a semiconductor element according to the first variation of the embodiment. FIG. 8 is a flowchart for describing a manufacturing method for a semiconductor device according to the first variation of the embodiment. As illustrated in FIG. 7, the semiconductor element 1 according to the first variation has a mesa structure and a field plate structure. The semiconductor device 2 includes such a semiconductor element 1. Note that in FIG. 7, a step is drawn larger for description. The same applies to the following figures.

A manufacturing method for the semiconductor device 2 including the semiconductor element 1 will be described. Steps ST11 and ST12 are performed in a manner the same as or similar to that in the embodiment. In other words, the semiconductor element 1 is manufactured in a manner the same as or similar to that in the embodiment. Step ST21 is performed in a manner the same as or similar to that in the embodiment. That is, after performing steps ST11 to ST21 in the embodiment, steps ST22 to ST25 are performed.

Part of the GaN layer 33 is dry-etched (step ST22). More specifically, part of the surface 33a of the GaN layer 33 is dry-etched. Specifically, a periphery of the GaN layer 33 is dry-etched. An end portion of the surface 33a of the GaN layer 33 has a mesa structure. In other words, a periphery of the remaining GaN layer 33 has a mesa step 33s. The periphery of the GaN layer 33 has a surface 33c at a position closer to the GaN layer 32 than the surface 33a, in other words, at a position one step lower.

The Schottky metal film 41 that forms a Schottky junction with the GaN layer 33 is formed on the exposed surface 33a side (step ST23). The Schottky metal film 41 covers the exposed surface 33a of the GaN layer 33. Thus, the Schottky junction is provided between the GaN layer 33 and the Schottky metal film 41.

An insulating film 42, which is an insulating layer, is formed (step ST24). The insulating film 42 covers the exposed GaN layer 33 and a periphery of the Schottky metal film 41. The insulating film 42 includes a wall portion 421 covering the periphery of the Schottky metal film 41, a wall portion 422 covering a side surface 33b of the GaN layer 33, and a wall portion 423 covering the surface 33c of the GaN layer 33. The wall portion 421 has an opening that exposes the Schottky metal film 41 in the center portion. The wall portion 422 extends downward in the layering direction from an outer end portion of the wall portion 421. The wall portion 423 extends outward from a lower end portion of the wall portion 422 in the layering direction.

An upper surface electrode metal film 43 is formed on the Schottky metal film 41 and on the insulating film 42 (step ST25). The upper surface electrode metal film 43 forms a so-called field plate on the insulating film 42. An outer end portion of the wall portion 423 of the insulating film 42 is not covered with the upper surface electrode metal film 43.

Step ST21, which is a step of forming the back surface electrode, may be performed after step ST25 when the annealing temperature of the back surface electrode does not affect the Schottky metal film 41, the insulating film 42, and the upper surface electrode metal film 43.

In the above-described manner, the semiconductor element 1 having the mesa structure and the field plate structure is manufactured. Having the field plate can reduce the electric field applied to the end portion of the upper surface electrode, resulting in a device with high breakdown voltage. The field plate may be separated from the upper electrode.

In this variation, the electric field applied to the end portion of the upper surface electrode can be reduced by having the mesa step 33s. In this variation, the electric field applied to the end portion of the upper surface electrode can be reduced by having the field plate. Thus, according to this variation, the semiconductor element 1 with a high maximum peak current can be manufactured. According to this variation, the semiconductor element 1 with improved voltage resistance can be manufactured.

In this variation, the crystal direction in the voltage resistant end portion is the lateral direction, and the occurrence of crystal defects on the surface along the electric field direction, which may serve as paths for leakage current in the semiconductor element 1, can be reduced. Thus, in this variation, the height of the mesa step 33s in the layering direction can be reduced. In this variation, the width w2 of the voltage resistant end portion can be narrowed. These allow the ratio of the conductive area of the semiconductor element 1 to be increased in this variation. According to the present embodiment, the semiconductor element 1 can be smaller, thereby reducing costs.

### Second Variation

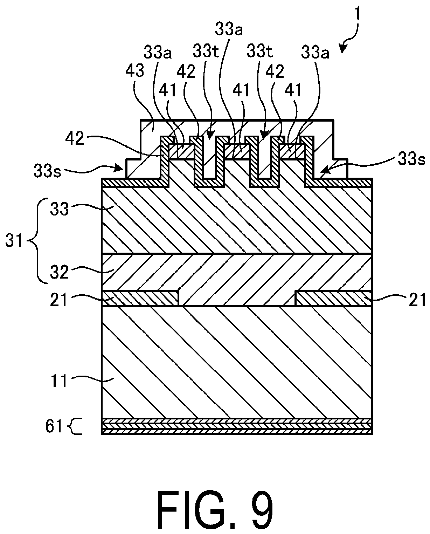

A description is given of a second variation of the embodiment using FIG. 9. FIG. 9 is a cross-sectional schematic view for describing a semiconductor element according to the second variation of the embodiment. The semiconductor element 1 according to the second variation has a mesa structure, a field plate structure, and a trench structure.

A manufacturing method for the semiconductor device 2 including the semiconductor element 1 will be described. Step ST11 to step ST13 are performed in a manner the same as or similar to that in the embodiment. In other words, the semiconductor element 1 is manufactured in a manner the same as or similar to that in the embodiment. Step ST21 is performed in a manner the same as or similar to that in the embodiment. That is, after performing steps ST11 to ST21 in the embodiment, steps ST22 to ST25 are performed. In the following, steps different from those in the first variation will be described.

In step ST22, the mesa step 33s and a trench structure 33t are formed in the GaN layer 33 by dry etching. More specifically, a periphery of the remaining GaN layer 33 has the mesa step 33s. The trench structure 33t having a groove shape is formed inside the periphery of the remaining GaN layer 33. In the GaN layer 33, part of the surface 33a remains except for the area where the mesa step 33s or the trench structure 33t is formed.

In step ST23, the Schottky metal film 41 is formed on the surface 33a remaining inside the mesa step 33s.

In step ST24, the insulating film 42 is formed to cover the exposed surface of the GaN layer 33 that is not covered with the Schottky metal film 41.

In step ST 25, the upper surface electrode metal film 43 is formed on the Schottky metal film 41 and on the insulating film 42.

In the above-described manner, the semiconductor element 1 having the mesa structure, the field plate structure, and the trench structure is manufactured.

In this variation, the electric field applied to the center portion of the upper surface electrode can be reduced by having the trench structure. According to this variation, the semiconductor element 1 with higher voltage resistance can be manufactured.

### Third Variation

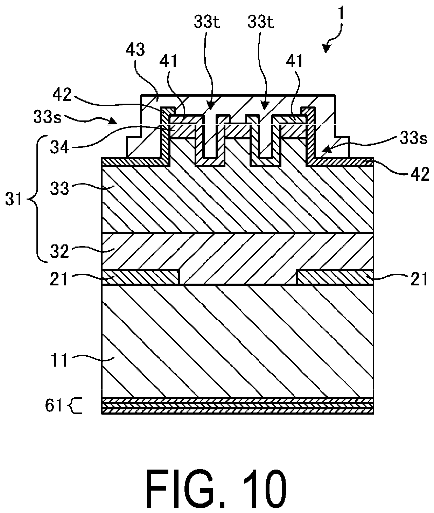

A description is given of a third variation of the embodiment using FIG. 10. FIG. 10 is a cross-sectional schematic view for describing a semiconductor element according to the third variation of the embodiment. The semiconductor element 1 according to the third variation has a mesa structure, a field plate structure, and a JBS structure. According to the third variation, in the semiconductor layer 31 of the semiconductor element 1, the GaN layer (first semiconductor layer) 32, which is an n+ type semiconductor layer, the GaN layer (second semiconductor layer) 33, which is an n- type semiconductor layer, and a GaN layer (first semiconductor layer) 34, which is a p+ type semiconductor layer, are layered in order from the substrate 11.

A manufacturing method for the semiconductor device 2 including the semiconductor element 1 will be described. In the third variation, after performing step ST11 to step ST13, step ST14 (not shown) is performed.

In order to obtain a desired higher purity concentration profile, the p+ type GaN layer 34 with a high impurity concentration is formed to cover the GaN layer 33 (step ST14).

The doping amount of p-type impurities is controlled so that the GaN layer 34 has a hole carrier concentration of equal to or higher than 10¹⁸ cm⁻³. The surface of the GaN layer 34 becomes substantially flat. The thickness of the GaN layer 34 in the layering direction is, for example, 20 nm or more.

Steps ST21 and ST25 are performed in a manner the same as or similar to that in the second variation.

In step ST22, part of the GaN layer 34 and part of the GaN layer 33 are dry-etched to form the mesa step 33s and the trench structure 33t.

In step ST23, the Schottky metal film 41 is formed on the GaN layer 34 and the GaN layer 33, which are exposed inside the mesa step 33s and outside the GaN layer 34 and the GaN layer 33 left in the center. In other words, the Schottky metal film 41 is disposed except for the center portion and the end portion when viewed in the layering direction.

In step ST24, the insulating film 42 is formed to cover the exposed surface of the GaN layer 33 that is not covered with the Schottky metal film 41.

In the above-described manner, the semiconductor element 1 having the mesa structure, the field plate structure, and the JBS structure is manufactured. Note that the semiconductor element 1 having the JBS structure is not limited thereto. For example, the semiconductor element 1 may be a Schottky barrier diode.

In this variation, the electric field applied to the center portion of the upper surface electrode can be reduced by having the JBS structure. According to this variation, the semiconductor element 1 with higher voltage resistance can be manufactured. In this variation, the leakage current can be reduced.

The embodiment disclosed by the present application can be modified without departing from the main point or the scope of the present invention. The embodiment and variations thereof disclosed in the present application can be combined as appropriate.

Embodiments have been described in order to fully and clearly disclose the technology according to the appended claims. However, the appended claims are not to be limited to the embodiments described above and may be configured to embody all variations and alternative configurations that those skilled in the art may make within the underlying matter set forth herein.

### REFERENCE SIGNS

1 Semiconductor element
2 Semiconductor device
11 Substrate
11a Front surface
21 Mask
22 Opening
31 Semiconductor layer
32 GaN layer (first semiconductor layer)
33 GaN layer (second semiconductor layer)
61 Back surface electrode
200 Mounting substrate
201 Electrode pad
202 Electrode pad

## Claims

1. A method of manufacturing a semiconductor element, the method comprising:
forming a mask on a front surface of a substrate, the mask having an opening to expose the front surface;
growing a first semiconductor layer by epitaxially growing a semiconductor along the mask, starting from the front surface exposed through the opening; and
growing a second semiconductor layer on a surface located opposite to the substrate in a layering direction; and
providing an electrode located opposite to the surface of the first semiconductor layer in the layering direction, wherein
a width from an end portion of the surface to the electrode is smaller than a width of the mask.

2. The method of manufacturing a semiconductor element according to claim 1, wherein
the width of the mask is 10 µm or more.

3. The method of manufacturing a semiconductor element according to claim 1 or 2, comprising:
having a mesa structure at an end portion of the surface located on an opposite side to the substrate in the layering direction and on which the electrode is provided.

4. The method of manufacturing a semiconductor element according to any one of claims 1 to 3, comprising:
having a field plate structure.

5. The method of manufacturing a semiconductor element according to any one of claims 1 to 3, comprising:
having a trench structure.

6. The method of manufacturing a semiconductor element according to any one of claims 1 to 3, comprising:
having a JBS structure.

7. The method of manufacturing a semiconductor element according to any one of claims 1 to 6, wherein
the first semiconductor layer and the second semiconductor layer are hexagonal when viewed in the layering direction.

8. The method of manufacturing a semiconductor element according to any one of claims 1 to 7, wherein
the mask is interposed between the substrate and the first semiconductor layer inside the semiconductor element.

9. A semiconductor element manufactured by the method of manufacturing a semiconductor element according to any one of claims 1 to 8, wherein
the mask is interposed between the substrate and the first semiconductor layer inside the semiconductor element.

10. A semiconductor device comprising:
a semiconductor element manufactured by the method of manufacturing a semiconductor element according to any one of claims 1 to 8.
